Europäisches Patentamt

European Patent Office

Office européen des brevets

(11) Veröffentlichungsnummer: **0 141 274**
**A2**

(12) # EUROPÄISCHE PATENTANMELDUNG

(21) Anmeldenummer: 84111783.1

(22) Anmeldetag: 03.10.84

(51) Int. Cl.⁴: **H 01 L 27/02**
**H 01 L 23/52**

(30) Priorität: 20.10.83 DE 3338131

(43) Veröffentlichungstag der Anmeldung:
15.05.85 Patentblatt 85/20

(84) Benannte Vertragsstaaten:
FR GB IT NL SE

(71) Anmelder: TELEFUNKEN electronic GmbH
Theresienstrasse 2
D-7100 Heilbronn(DE)

(72) Erfinder: Clauss, Hermann, Dr. Dipl.-Ing.
Erich-Flister-Strasse 13/3
D-7105 Leingarten(DE)

(72) Erfinder: Nutz, Karl-Diether, Dipl.-Ing.
Blumenstrasse 33
D-7101 Oedheim(DE)

(74) Vertreter: Maute, Hans-Jürgen, Dipl.-Ing.
TELEFUNKEN electronic GmbH Theresienstrasse 2
D-7100 Heilbronn(DE)

(54) I2L-Schaltung.

(57) Bei einer I²L-Schaltung ist zur Ansteuerung der Injektoren eine polykristalline Siliciumleitbahn vorgesehen, deren Oberfläche oxidiert ist. Über diese oxidierte Siliciumleitbahn verlaufen metallische Leitbahnen, die für die Kontaktierung von Halbleiterzonen der übrigen Schaltung erforderlich sind.

FIG. 5

TELEFUNKEN electronic GmbH
Theresienstraße 2, 7100 Heilbronn

Heilbronn, den 13.10.83
PTL-HN-La-goe HN 83/6

## $I^2$L-Schaltung

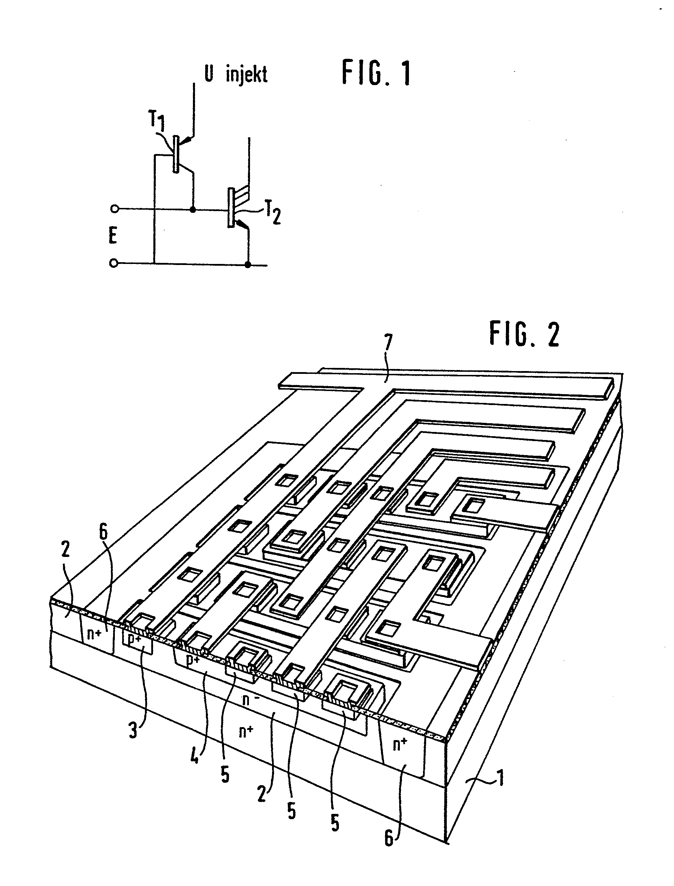

Das Grundelement einer $I^2$L-Schaltung ist der Inverter. Ein Inverter besteht nach der Figur 1 aus der Zusammenschaltung zweier Transistoren T1 und T2. Ist der Eingang der in der Figur 1 dargestellten Schaltung offen, so ist der Transistor T2 entsprechend der Inverterfunktion leitend. Ist der Eingang E dagegen kurzgeschlossen, so ist der Transistor T2 entsprechend der Inverterfunktion nichtleitend.

Die Figur 2 zeigt die technologische Realisierung eines Inverters. Die Schaltung der Figur 2 besteht aus einem Halbleitersubstrat 1 mit einer auf dem Substrat 1 befindlichen epitaktischen Schicht 2. Das Substrat 1 und die epitaktische Schicht 2 haben den gleichen Leitungstyp. In der epitaktischen Schicht 2 befinden sich die Halbleiterzonen 3 und 4 und in den Halbleiterzonen 4 die Halbleiterzonen 5. Der Leitungstyp der Halbleiterzonen 3 und 4 ist dem der epitaktischen Schicht 2 entgegengesetzt. Der Transistor T1 der Figur 1 ist ein Lateraltransistor, der durch die Halbleiterzone 3, die epitaktische Schicht 2 und die Halbleiterzone 5 gebildet wird. Die Halbleiterzone 3 hat dabei die Injektor- bzw. Emitterfunktion, die epitaktische Schicht 2 die Basisfunktion und die Halbleiterzone 4 die Kollektorfunktion des Lateraltransistors T1. Der Transistor T2 der Figur 1 ist ein Vertikaltransistor, der gemäß der Figur 2 durch die Halbleiterzone 5, die Halbleiterzone 4 und die epitaktische Schicht 2 gebildet wird. Die epitaktische Schicht 2 hat dabei die Emitterfunktion, die Halbleiterzone 4 die Basisfunktion und die Halbleiterzonen 5 haben die Funktion von Kollektorzonen (Mehrkollektortransistor). Die Halbleiterzone 6 bildet eine niederohmige Anschlußzone zum Substrat 1.

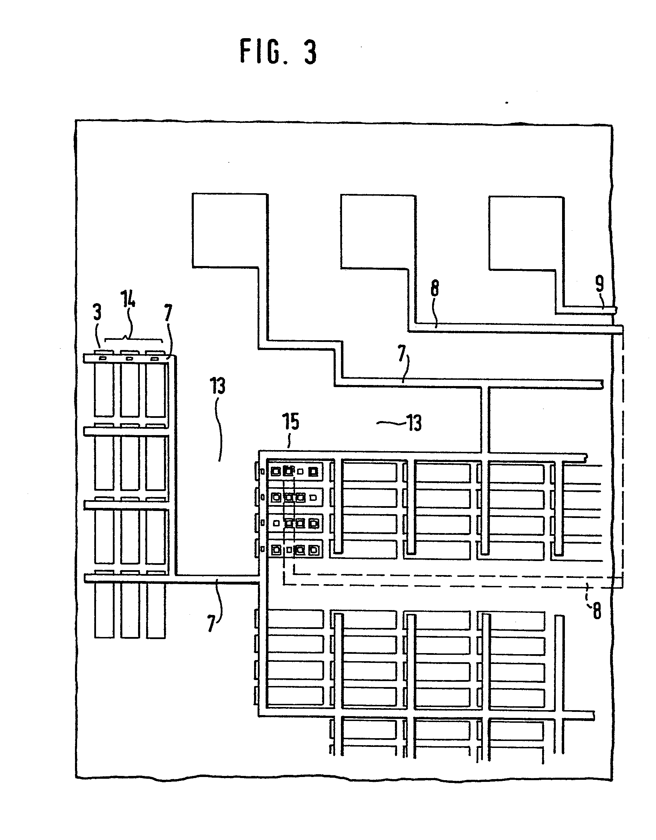

Nach der Figur 2 werden alle Injektorzonen 3 durch eine gemeinsame Leitbahn 7 angesteuert. Wird mit nur einer Verdrahtungsebene gearbeitet, so muß beim Design der Injektorleitbahn 7 auf den Verlauf der übrigen Leitbahn der Schaltung Rücksicht genommen werden und umgekehrt, da bei nur einer Verdrahtungsebene in der üblichen Technik keine Leitungskreuzungen möglich sind. Ohne Leitungskreuzungen können jedoch, wie die Figur 3 zeigt, die Leitbahnen nicht optimal, d.h. auf dem kürzesten Weg zu den zu kontaktierenden Halbleiterzonen geführt werden. Dies gilt nicht nur für die Injektorleitbahn 7, sondern auch für die anderen Leitbahnen, die mit Ausnahme der Leitbahnen 8 und 9 der besseren Übersichtlichkeit wegen nicht dargestellt sind.

Das angesprochene Problem kann zwar durch eine Zweiebenenverdrahtung gelöst werden, doch führt eine solche Lösung zu erheblichen Prozeßkosten, deutlich reduzierten Fertigungsausbeuten und nicht zuletzt zu enormen meßtechnischen Problemen bei der Chip-Analyse und der Ausbeuteoptimierung. Der Erfindung liegt deshalb die Aufgabe zugrunde, eine $I^2L$-Schaltung anzugeben, die ohne großen Aufwand möglichst wenig Design-Probleme bei der Erstellung des Layouts von $I^2L$-Schaltungen ergibt und eine möglichst kurze Linienführung vor allem für die Injektorleitbahn, aber auch für die anderen Leitbahnen ermöglicht. Diese Aufgabe wird bei einer $I^2$L-Schaltung nach der Erfindung dadurch gelöst, daß zur Ansteuerung der Injektoren eine polykristalline Siliciumleitbahn vorgesehen ist, deren Oberfläche oxidiert ist, und daß über diese oxidierte Siliciumleitbahn metallische Leitbahnen verlaufen, die für die Kontaktierung von Halbleiterzonen der übrigen Schaltung erforderlich sind.

Gemäß einer Weiterbildung der Erfindung ist die Leitbahn für die Injektoren zumindest teilweise maschenförmig ausgebildet. Eine Masche der Injektorleitbahn umgibt dabei vorzugsweise mehrere Inverter. Die anderen Leitbahnen, die nicht die Injektoren der Inverter kontaktieren und metallisch sind, bestehen beispielsweise aus Aluminium.

Die Erfindung wird im folgenden an einem Ausführungsbeispiel erläutert.

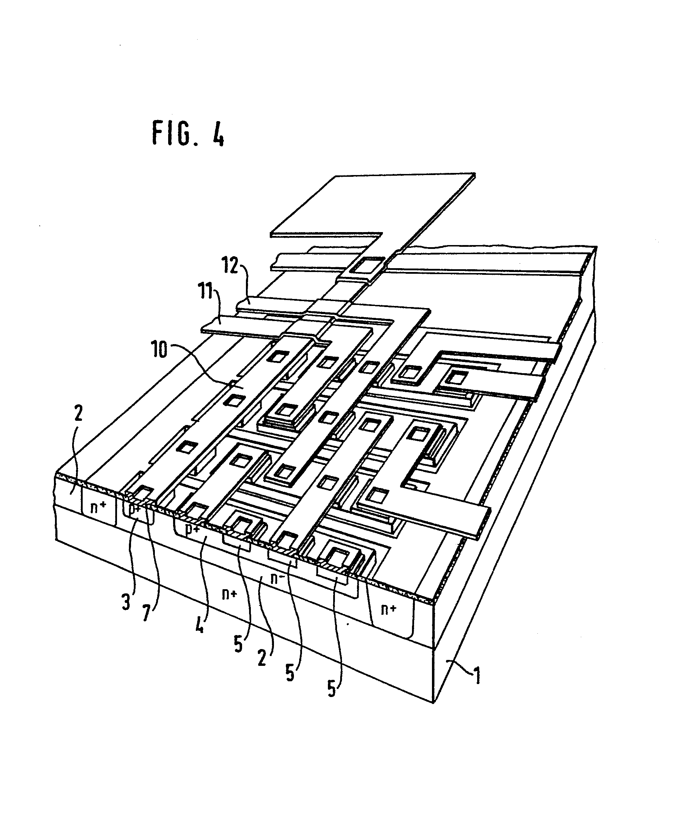

Die Figur 4 zeigt eine $I^2$L-Schaltung nach der Erfindung, bei der gemäß der Erfindung die Injektorleitbahn 7 aus Silicium besteht. Die Oberfläche der Siliciumleitbahn 7 ist oxidiert, so daß sich auf der Oberfläche der Siliciumleitbahn 7 eine Isolierschicht 10 in Gestalt einer Oxidschicht befindet. Da die Injektorleitbahn 7 mit der Isolierschicht 10 bedeckt ist, können andere Leitbahnen wie z.B. die metallischen Leitbahnen 11 und 12 die Injektorleitbahn 7 kreuzen bzw. überqueren.

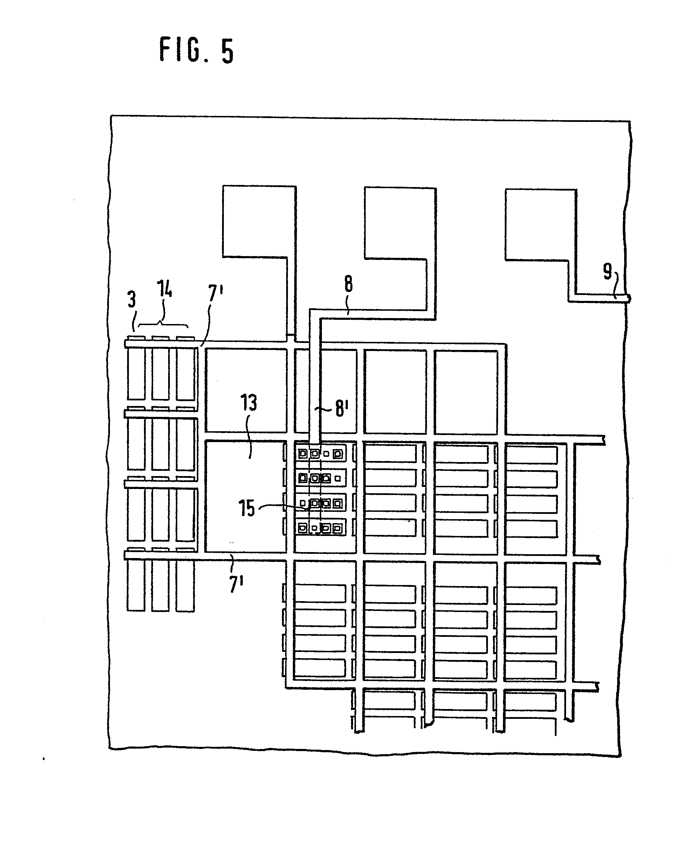

Den wesentlichen Vorteil der Erfindung zeigt eine Gegenüberstellung der Figuren 3 und 5. Die Figur 3 zeigt eine bekannte $I^2$L-Schaltung mit ausschließlich

metallischen Leitbahnen, die sämtlich in einer Ebene verlaufen, so daß keine Zweiebenen-Verdrahtung vorliegt. Da bei der Schaltung der Figur 3 im Bereich 13 nicht dargestellte Schaltungsteile liegen, die von einer metallischen Leitbahn nicht überquert werden können, können die Injektoren 3 im Bereich 14 nur über ein relativ langes Teilstück der Injektorleitbahn 7 erreicht werden, während bei der Schaltung der Figur 5 gemäß der Erfindung zur Kontaktierung der Injektoren 3 im Bereich 14 nur das kurze Teilstück 7 der Injektorleitbahn 7 erforderlich ist. Dasselbe gilt für die Leitbahn 8, die zur Kontaktierung von Inverter-Halbleiterzonen 15 dient, die nicht Injektoren sind. Während bei der Schaltung der Figur 3 die Leitbahn 8 einen erheblichen Umweg machen muß, um zu den Halbleiterzonen 15 zu gelangen, erfolgt die Kontaktierung der Halbleiterzonen 15 bei der Schaltung der Figur 5 auf kürzestem Weg, da die Siliciumleitbahn 7 bei der Schaltung der Figur 5 mittels des Leitbahnstücks 8' überquert werden kann.

Die Figur 5 zeigt noch mehr Beispiele für kürzere Leitbahnführung und einfacheres Design, die so offensichtlich sind, daß im einzelnen nicht darauf eingegangen zu werden braucht. Die vielen Vorteile der Erfindung lassen sich am besten bei Betrachtung einer Gesamtschaltung einer nach der Erfindung aufgebauten $I^2L$-Schaltung erkennen, von der natürlich - aus Raumgründen - , wie in Figur 5 geschehen, nur ein sehr kleiner Teilausschnitt zeichnerisch dargestellt werden kann.

Wie die Figur 5 zeigt, ist die Injektorleitbahn 7 vorzugsweise maschenförmig ausgebildet, da eine maschenförmige Ausbildung der Injektorleitbahn eine besonders günstige und auf kürzestem Weg erfolgende Injektorkontaktierung zuläßt. Eine möglichst kurze Leitbahnführung ist nicht nur aus Design-Gründen, sondern vor allem auch deshalb erforderlich, weil möglichst alle Injektoren einer $I^2L$-Schaltung möglichst das gleiche Potential erhalten sollen, was nur durch eine relativ kurze Leitbahnführung ohne wesentliche Potentialverluste möglich ist. Bei der Schaltung der Figur 5 sind jeweils mehrere Inverter innerhalb einer Masche des Maschensystems der Injektorleitbahn angeordnet.

TELEFUNKEN electronic GmbH
Theresienstraße 2, 7100 Heilbronn

Heilbronn, den 13.10.83
PTL-HN-La-goe HN 83/6

Patentansprüche

1) $I^2$L-Schaltung, dadurch gekennzeichnet, daß zur Ansteuerung der Injektoren eine polykristalline Siliciumleitbahn vorgesehen ist, deren Oberfläche oxidiert ist, und daß über diese oxidierte Siliciumleitbahn metallische Leitbahnen verlaufen, die für die Kontaktierung von Halbleiterzonen der übrigen Schaltung erforderlich sind.

2) $I^2$L-Schaltung nach Anspruch 1, dadurch gekennzeichnet, daß die Leitbahn für die Injektoren zumindest teilweise maschenförmig ausgebildet ist.

3) $I^2$L-Schaltung nach Anspruch 2, dadurch gekennzeichnet, daß jeweils eine Masche der Injektorleitbahn mehrere Inverter umgibt.

0141274

FIG. 1

FIG. 2

FIG. 3

FIG. 4

FIG. 5